# EUROPEAN PATENT SPECIFICATION

(11) **EP 2 333 017 B1**
(45) Date of publication and mention of the grant of the patent: **18.07.2012**
(21) Application number: 10150586.5
(22) Date of filing: 12.01.2010
(51) Int. Cl.: C09B 23/10, H01L 51/05, H01L 51/42, H01L 51/00

(54) **A novel dye-dopant, a composition comprising the same and a photovoltaic device including such composition**
Neuartige Farbstoffdotierungssubstanz, Zusammensetzung damit und Fotovoltaikvorrichtung mit einer solchen Zusammensetzung
Nouveau dopant de colorant, composition le comportant et dispositif photovoltaïque incluant cette composition

(30) Priority: 26.10.2009 TW 98136209
(43) Date of publication of application: 15.06.2011
(73) Proprietor: Taiwan Textile Research Institute, Tu-Chen City, Taipei Hsien, Taiwan (CN)
(72) Inventor: Wang, Rui-Ren, Taipei Hsien (TW); Wang, Lee-Yih, Taipei Hsien (TW); Liang, Chi-Wei, Taipei Hsien (TW)
(74) Representative: Lang, Christian

(56) References cited:
- EP-A1- 2 072 557
- WO-A1-2009/026097
- CA-A1- 2 625 306
- WANLI MA, CUIYING YANG, XIONG GONG, KWANGHEE LEE, AND ALAN J. HEEGER: "Thermally Stable, Efficient Polymer Solar Cells with Nanoscale Control of the Interpenetrating Network Morphology", ADVANCED FUNCTIONAL MATERIALS, vol. 15, 2005, pages 1617-1622, XP002630135,

## Description

### RELATED APPLICATIONS

This application claims priority to Taiwan application no. 98136209, filed October 26, 2009, the entirety of which is incorporated herein by reference.

### BACKGROUND

### Field of Invention

The present disclosure in general relates to a novel dye-dopant, a composition comprising the same and a photovoltaic device (e.g., an organic solar cell) including such composition.

### Description of Related Art

Hand-held devices such as cell phones, personal digital aids (PDAs), music players, satellite navigation devices and etc have become the most popular products with their market shares increase significantly throughout the years. However, these products all share common shortcomings, including but are not limiting to, low extended battery life and difficulty in re-charging. The related art has been trying to find a solution or develop a technique that would use the seeming inexhaustible light source, sun light, as the power source for such devices.

Solar cells are now generally categorized based on the materials that are used in the cells, such as silicon, inorganic semiconductors, dye-sensitive materials and organic semiconductors which include organic polymeric material and organic small molecules.

This disclosure aims at improving organic polymeric material for use in the solar cells. Novel dye compounds are developed for the afore-mentioned purpose- These novel compounds may act as dopants of the active layers of the solar cells to enhance the electron transferring efficiency within the cells and thereby increasing the photo-voltaic converting efficiency of the devices.

WO 2009/026097 A1 relates to a solar cell comprising an active organic layer having an electron donating organic material and an electron accepting organic material. CA 2625306 A1 relates to an organic electronic device such as a solar cell which includes a series of electron acceptors-cored regioregular oligothiophenes. EP 2 072 557 A1 relates to a photovoltaic device, the electron donating organic material of which contains a particular conjugated polymer represented by formula (1) of said document.

### SUMMARY

In view of the above, one objective of this disclosure aims to provide a novel dye compound, which acts as a dopant for doping an active layer of an organic solar cell so as to enhance the photovoltaic conversion efficiency of the solar cell. The novel dye-dopant of this disclosure is characterized in having the structure of formula (I): 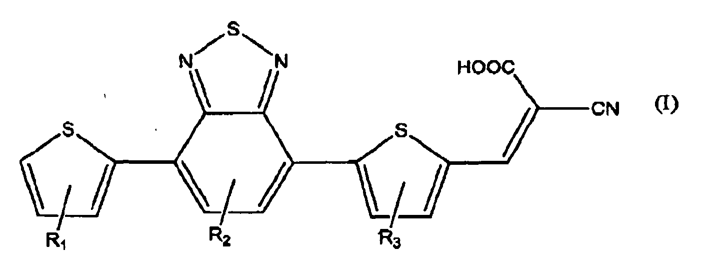 wherein R₁, R₂ and R₃ are independently hydrogen or C₁₋₈ alkyl.

In one specific example, R₁, R₂ and R₃ of the dye-dopant of formula (I) are independently hydrogen atom, that is, the dye-dopant is the compound having formula (II):

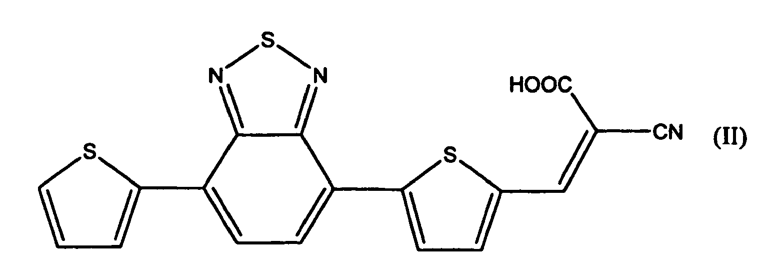

In the second aspect, the disclosure relates to a composition for fabricating an active layer of an organic solar cell. The composition includes:
poly-(3-hexylthiophene) (P3HT);
a dye-dopant having formula (I), 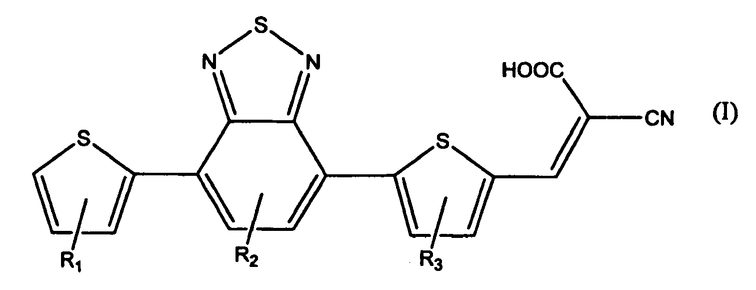
wherein R₁, R₂ and R₃ are independently hydrogen or C₁₋₈alkyl; and [6,6]-phenyl-C61-butyric acid methyl ester (PCBM);
wherein P3HT, the dye dopant and PCBM exist in the composition in a weight ratio ranges from about 3:1:3 to about 10:1:10.

In one embodiment, P3HT, the dye dopant and PCBM exist in the composition in a weight ratio of about 15:2:15.

In the third aspect, the disclosure relates to a method of fabricating an organic solar cell. The method includes steps of:
(a) providing a substrate in a processing chamber;
(b) forming a coating solution by dissolving the composition as described above in a solvent;
(c) coating the substrate with the coating solution and thereby forming an organic layer on the substrate; and
(d) forming a layer of electrode on the organic layer by physical vapor deposition.

In some embodiments, the substrate is made of plastic or glass, and may further comprise a layer of indium tin oxide thereon.

In step (b), the composition is dissolved in a solvent selected from the group consisting of toulene, chloroform, xylene, dichlorobenzene (DCB) or dimethyl sulfoxide (DMSO). In one example, the composition is dissolved in DCB.

In one embodiment, the method further comprises a step of spin coating a conductive layer on the substrate before step (c) is performed. In one example, the conductive layer is a film made of poly (3,4-ethylenedioxythiophene) poly (styrenesulfonate) (PEDOT: PSS).

In step (d), the physical vapor deposition may be any of thermal deposition, electron beam physical vapor deposition, sputter deposition or pulsed laser deposition. In one example, the physical vapor deposition is pulsed laser deposition.

In one embodiment, the method further comprises an optional step (e) of irradiating the substrate with a UV light, this optional step (e) is performed after step (d).

In another embodiment, the method further comprises a step (f) of annealing the substrate at a temperature ranges from about 120°C to 160°C for about 10-60 minutes, and step (f) is performed after step (e). In one example, step (f) comprises annealing the substrate at about 160°C for a period of about 30 minutes.

According to the fourth aspect of this disclosure, an organic solar cell is provided. The organic solar cell includes a substrate, which comprises in sequence, from bottom to top,
a layer of indium tin oxide (ITO) disposed on the substrate;
a layer of PEDOT:PSS disposed on the ITO layer;
an organic layer formed from a composition comprising:
P3HT;
a dye-dopant having formula (1): 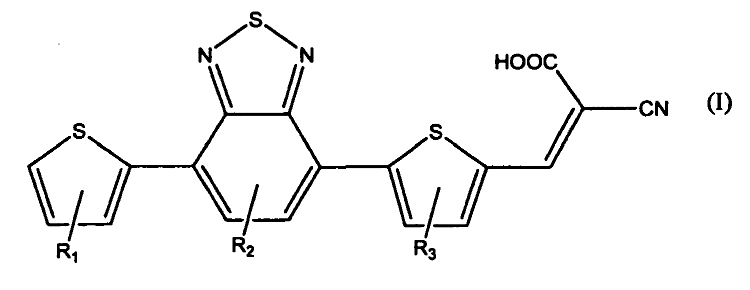 wherein R₁, R₂ and R₃ are independently hydrogen or C₁₋₈alkyl; and [6,6]-phenyl-C61-butyric acid methyl ester (PCBM);
Wherein the composition comprises P3HT, the dye-dopant of formula (I), and PCBM in a weight ratio ranges from about 3:1:3 to about 10:1:10; and
a layer of electrode;
wherein the substrate has or has not been annealed.

According to one specific embodiment, the compound of formula (I) is characterized in having R₁, R₂ and R₃ are independently hydrogen; the electrode layer comprises aluminum; the substrate has not been annealed and the solar cell thus fabricated has a photo-voltaic converting efficiency of about 2.47%.

According to another specific embodiment, the compound of formula (I) is characterized in having R₁, R₂ and R₃ are independently hydrogen; the electrode layer comprises aluminum; the substrate has been annealed at a temperature of about 160°C for a period of about 30 minutes; and the solar cell thus fabricated has a photo-voltaic converting efficiency of about 3.42%.

These and other features, aspects, and advantages of the present disclosure will become better understood with reference to the following description and appended claims.

### DETAIL DESCRIPTION OF ILLUSTRATED EMBODIMENTS

Reference will now be made in detail to the preferred embodiments of the disclosure.

Embodiments of the present disclosure are directed to a novel dye-dopant for doping an active layer of a solar cell and thereby increasing the photo-voltaic converting efficiency of the solar device.

The novel dye-dopant of this disclosure is a compound having formula (I): 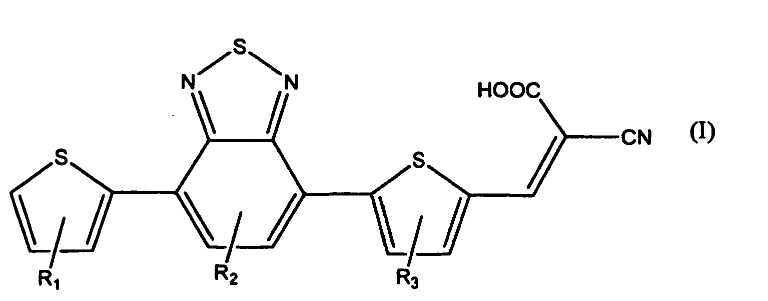 wherein R₁, R₂ and R₃ are independently hydrogen or C₁₋₈alkyl.

The C₁₋₈alkyl of the compound of formula (I) includes, but is not limited to, methyl, ethyl, propyl, isopropyl, n-butyl, sec-butyl, n-pentyl, isopentyl, neopentyl, n-hexyl, 2-methylpentyl, 3-methylpentyl, 2,2-dimethylbutyl, 2,3-dimethylbutyl, n-heptyl, 2-methylhexyl, 3-methylhexyl, 2,2-dimethylpentyl, 2,3-dimethylpentyl, 3,3-dimethylpentyl, 2,4-dimethylpentyl, n-octyl, 2-methylheptyl, 3-methylheptyl, 4-methylheptyl, 2,2-dimethylhexyl, 2,3-dimethylhexyl, 2,4-dimethylhexyl, 2,5-dimethylhexyl, 2,3,4-trimethylpentyl, 2,23,-trimethylpentyl and 2,3,3-trimethylpentyl.

In one example, the compound of formula (I) is characterized in having R₁, R₂ and R₃ are independently hydrogen, in which case, the novel dye-dopant is the compound of formula (II):

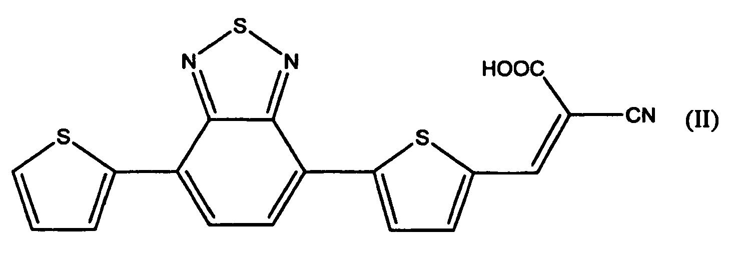

One skilled person in the related art may synthesize the novel dye-dopant of this disclosure in accordance with any known method without undue experimentation. References is now made to one preferred embodiment of this disclosure, in which the novel dye-dopant having formula (II) is used as an example to elucidate the scheme for synthesizing the novel dye-dopant of this disclosure.

According to one embodiment of this disclosure, compound of formula (II) is synthesized in according to the steps described in **Scheme I**.

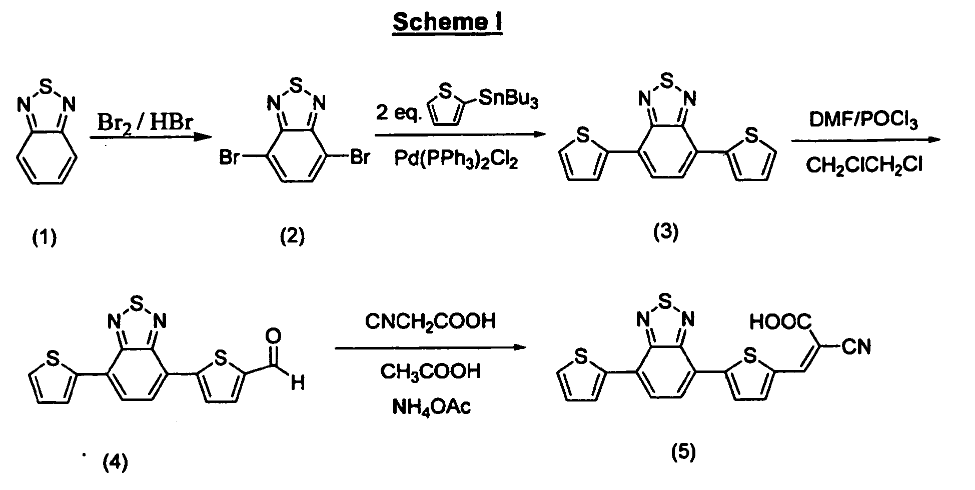

The starting material, 2,1,3-benzothiadiazole (compound (1)) is reacted with bromide and forms 4,7-dibromo-2,1,3-benzothiadiazole (compound (2)).

Sufficient amount of thiophene is reacted with n-butyl lithium and Bu₃SnCl in the presence of anhydrous tetrahydrofuran (THF) at -30 ° C to form (2-thiophenyl) tributyl tin.

Compound (2) (4,7-dibromo-2,1,3-benzothiadiazole) is then reacted with 2 equivalents of (2-thiophenyl) tributyl tin in the presence of a catalyst, Pd(Ph₃)Cl₂, to form 4,7-di(thiophen-2-yl)-2,1,3- benzothiadiazole (compound (3)).

Compound (3) is then reacted with POCl₃ in the presence of anhydrous dimethyl formamide (DMF) and dichloromethane, and thereby forms 5-(7-(thiophen-2-yl)- 2,1,3- benzothiadiazole-4-yl) thiophen-2-carbaldehyde (compound (4)).

Then, compound (4) is then mixed with cyanoacetic acid, ammonium acetate and acetic acid and thereby forms the desired product, compound (4).

According to another aspect of this disclosure, a composition for fabricating an active layer of an organic solar cell is provided. The composition comprises:
poly-(3-hexylthiophene) (P3HT);
a dye-dopant having formula (I), 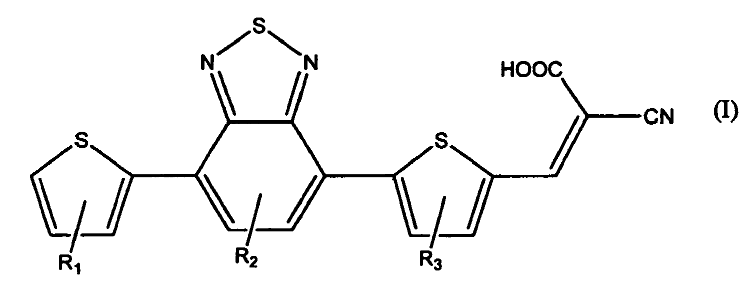 wherein R₁, R₂ and R₃ are independently hydrogen or C₁₋₈alkyl; and [6,6]-phenyl-C61-butyric acid methyl ester (PCBM);
wherein P3HT, the dye dopant and PCBM exist in the composition in a weight ratio ranges from about 3:1:3 to about 10:1:10.

In one embodiment, P3HT, the dye dopant of formula (I) and PCBM exist in the composition in a weight ratio ranges from about 3:1:3 to about 10:1:10.

In one specific embodiment, P3HT, the dye dopant of formula (I) and PCBM exist in the composition in a weight ratio of about 15:2:15. In one example, the dye-dopant of formula (I) is characterized in that R₁, R₂ and R₃ are independently hydrogen.

The composition may be dissolved in a solvent to form a coating solution, which is suitable to form an organic thin film on one surface of a substrate. Accordingly, according to one aspect of this disclosure, a method of fabricating an organic solar cell is provided. The method is characterized in having steps of:
- (a): providing a substrate in a processing chamber;
- (b): forming a coating solution by dissolving the composition as described above in a solvent;
- (c): coating the substrate with the coating solution and thereby forming an organic layer on the substrate; and
- (d): forming a layer of electrode on the organic layer by physical vapor deposition.

Suitable material of the substrate includes, but is not limited to, plastic or glass. In one example, the substrate is a flexible plastic substrate formed from a material such as polyimide. Further, the substrate may further comprise a layer of indium tin oxide.

In step (b), the solvent is dissolved in a solvent that is selected form the group consisting of: toulene, chloroform, xylene, dichlorobenzene (DCB) or dimethyl sulfoxide (DMSO). In one example, the composition is dissolved in DCB. In one example, the composition is dissolved in DCB.

In one embodiment, the method further comprises a step of spin coating a conductive layer on the substrate, before step (c) is performed. In one example, the conductive layer is a film made of a material, which includes, but is not limited to, polyacetylene, polyphenylacetylene, polydiphenylacetylene, polyaniline, polythiophene, poly (3,4-ethylenedioxythiophene) poly(styrenesulfonate) (PEDOT:PSS) and etc. In one example, the conductive layer is made of PEDOT: PSS.

In step (c), the coating solution form in step (b) is spin-coated onto a surface of the substrate, such as the conductive layer of the substrate, and thereby forming a thin film of organic material thereon, such organic layer may act as an active layer of the organic solar cell.

Next, in step (d), a layer of electrode is formed by physical vapor deposition, which may be any of thermal deposition, electron beam physical vapor deposition, sputter deposition or pulsed laser deposition. In one example, the physical vapor deposition is pulsed laser deposition. Suitable material for producing the electrode layer comprises aluminum. In one specific example, the electrode layer has a bilayer structure, wherein one layer therein is calcium, and the other layer is aluminum. In another example, the electrode layer is made of aluminum.

According to one embodiment, the method further comprises a step (e) of irradiating the substrate with a UV light for a period of about 5 to 10 minutes to complete the packaging procedure. For example, the substrate is irradiated with the UV light for about 5, 6, 7, 8, 9 or 10 minutes. In one example, the substrate is irradiated with the UV light for about 8 minutes.

In another embodiment, the method further comprises a step (f) of annealing the substrate at a temperature ranges from about 120°C to 160°C for a period of about 10-60 minutes. It is to be noted that step (f) is optional, and is usually performed after step (e). One skilled person in that art may determine whether step (e) is required or not, depends on the desired product and the process employed to produce such product. In one example, step (f) comprises annealing the substrate at about 160°C for a period of about 30 minutes.

Accordingly, it is another aspect of this disclosure to provide an organic solar cell. The organic solar cell includes a substrate, which comprises in sequence, from bottom to top,
a layer of indium tin oxide (ITO) disposed on the substrate;
a layer of PEDOT:PSS disposed on the ITO layer;
an organic layer formed from a composition comprising:
P3HT;
a dye-dopant having formula (I): 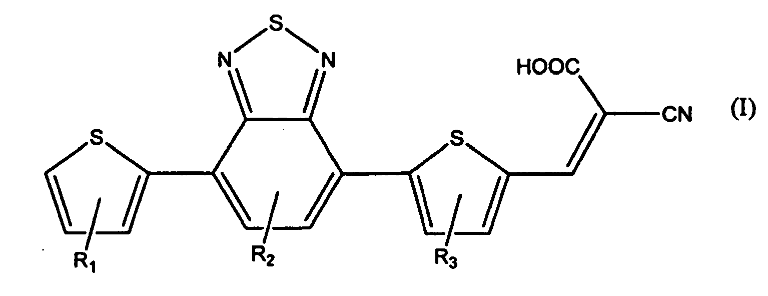 wherein R₁, R₂ and R₃ are independently hydrogen or C₁₋₈alkyl; and [6,6]-phenyl-C61-butyric acid methyl ester (PCBM);
Wherein the composition comprises P3HT, the dye-dopant of formula (I), and PCBM in a weight ratio ranges from about 3:1:3 to about 10:1:10; and
a layer of electrode;
wherein the substrate has or has not been annealed.

In one embodiment, suitable material for producing the electrode layer comprises aluminum. In one specific example, the electrode layer has a bi-layer structure, wherein one layer is calcium, and the other layer is aluminum. In another example, the electrode layer is made of aluminum.

Suitable condition for annealing the substrate includes heat-treating the substrate at a temperature ranges from about 120°C to 160°C, for example, the temperature is at about 120°C, 130°C, 140°C, 150°C or 160°C; and the heat treatment continues for a period of about 10 to 60 minutes, such as about 10, 20, 30, 40, 50 or 60 minutes.

In one specific embodiment, the substrate of the organic solar cell has not been annealed and the solar cell thus fabricated has a photo-voltaic converting efficiency of about 2.47%.

According to another embodiment, the substrate of the organic solar cell has been annealed at a temperature of about 160°C for a period of about 30 minutes; and the solar cell thus fabricated has a photo-voltaic converting efficiency of about 3.42%.

Unless defined otherwise, all technical and scientific terms used herein have the same meaning as commonly understood by one of ordinary skill in the art to which this invention belongs. Although any methods and materials similar or equivalent to those described herein can also be used in the practice of the present invention, exemplary methods and materials are described for illustrative purposes.

It must be noted that as used herein and in the appended claims, the singular forms "a", "an", and "the" include plural referents unless the context clearly dictates otherwise.

The following Examples are provided to illustrate certain aspects of the present invention and to aid those of skilled in the art in practicing this invention. These Examples are in no way to be considered to limit the scope of the invention in any manner.

### EXAMPLES

### EXAMPLE 1

### The synthesis of 2-cyano-3-(5-7-thiophen-2-yl)-2,1,3-benzothiadiazole-4-yl)thiophen-2-yl) acrylic acid (compound of formula II)

### 1.1 The synthesis of 4,7-dibromo-2,1,3-benzothiadiazole

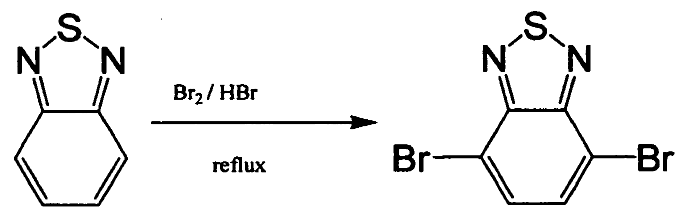

2,1,3-benzothiadiazole (0.9992 g, 7.34 mmole) was mixed with HBr (2 ml) in a tri-necked flask, and the mixture was refluxed at 130°C in an oil bath. About 1.5 ml of Br₂ was added slowly into the flask through a feeding funnel under vigorous stirring. Upon formation of a solid, additional amount of HBr (1 ml) was added to help mixing. The reaction was conducted for about 3 hours, then the oil bath was removed, and the resulted solid was washed with distilled water for several times. The solid was re-crystallized in MeOH/H₂O, and a white powder was obtained (1.942 g, yield: 90%).
¹H NMR (ppm, CDCl₃)□7.70(s, 2H)
¹³C NMR (ppm, CDCl₃)□113.89, 132.34, 152.94

### 1.2 The synthesis of tributyl (2-thienyl) stannate

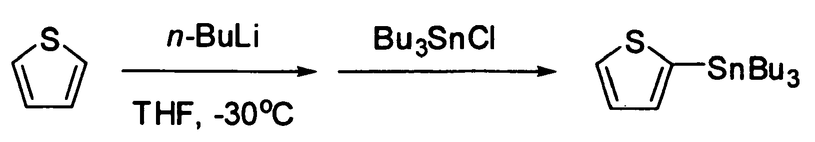

The utilities for performing this reaction were cleaned and dried for at least 4 hours in an oven of about 100°C. After drying, the utilities were immediately assembled and vacuumed and subsequently re-filled with dried nitrogen. The procedure was repeated for at least 3 times to remove any trace amount of oxygen or water therein.

Thiophene (10.0911 g, 120 mmole) and anhydrous tetrahydrofuran (THF) (100 ml) were mixed in a tri-necked flask in the presence of nitrogen, and n-butyl lithium (1.6 M, 41.25 ml, 66 mmole) was added through a feeding funnel. Specifically, the pressure of a reactor was maintained at a positive level by the aid of the nitrogen, then, the tri-necked flask was placed within this low temperature reactor (about -30°C), and the mixture in the tri-necked flask was continuously stirred for about 10 minutes, then n-butyl lithium was then added in drop-wise manner into the flask through the feeding funnel. The temperature of the reactor was maintained at -30°C and the reaction was allowed to continue for at least 1.5 hours. Bu₃SnCl (20.11 g, 61.8 mmole) was injected into the tri-necked flask by use of a double-headed syringe, the temperature of the reactor was kept at -30°C for another 30 minutes, then allowed it to return to room temperature slowly. The reaction was then terminated by adding NaHCO₃ solution (100 ml) into the flask. The resulted mixture were extracted with hexane (100 ml each time) for 3 times, and washed with saturated solutions of NaCl and NaHCO₃, respectively. The organic layer was dried with Na₂SO₄, and then filtered and concentrated and purified by a reduced pressure distillation with an external temperature of about 160 ° C and an internal temperature of about 128°C, a colorless oil was obtained (17.863 g; yield: 79.8%).

¹H NMR (ppm, CDCl₃)□0.88(t, 9H), 1.09(m, 6H), 1.32(m, 6H), 1.54(t, 6H), 7.18(d, 1H), 7.25(dd, 1H), 7.63(d, 1H)

### 1.3 The synthesis of 4,7-di(thiophen-2-yl)-2,1,3-benzothiadiazole

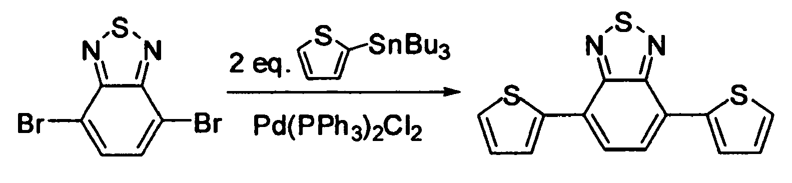

4,7-dibromo-2,1,3-benzothiadiazole of example 1.1 (2.026 g; 6.89 mmole) was placed in a tri-necked flask and the flask was subsequently filled with dried nitrogen, then anhydrous tetrahydrofuran (50 ml) and tributyl (2-thienyl) stannate of example 1.2 (6.7358 g; 20.7 mmole) were added. A catalyst solution was prepared by dispersing Pd(PPh₃)Cl₂ (107 ml, 0.15 mmole) in THF (5 ml) with an aid of sonification. The catalyst solution was then injected into the tri-necked flask, and the reaction was allowed to proceed by refluxing the mixture overnight at about 70°C. After the reaction was completed, the solvent was removed by reduced pressure evaporation, and the products were purified by column chromatography (moving phase: hexane/CH₂Cl₂ = 1/1). The concentrated solid was then re-crystallized with toluene/methanol, and an orange crystal was obtained. (1.5732 g; yield: 76%)

¹H NMR (ppm, CDCl₃)□7.20(dd, 1H), 7.44(d, 1H), 7.86(s, 1H), 8.10(d, 1H)

### 1.4 The synthesis of 5-7-(thiophen-2-yl)-2,1,3-benzothiadiazole-4-yl)thiophen-2-carbaldehyde

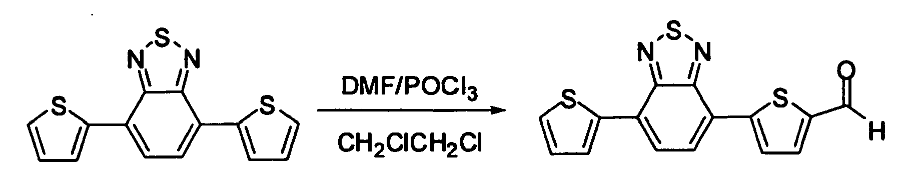

4,7-di(thiophen-2-yl)-2,1,3-benzothiadiazole of example 1.3 (1.9998 g; 6.66 mmole) was placed into a flask with a rounded bottom, which was pre-filled with dried nitrogen, 1,2-dichloroethane (30 ml) was then added to dissolve 4,7-di(thiophen-2-yl)-2,1,3-benzothiadiazole of example 1.3 therein. POCl₃ (0.71 ml, 7.62 mmole) and anhydrous DMF (0.56 ml, 7.21 mmole) were subsequently added under an ice bath, the mixture was stirred for 10 minutes before removing the ice bath. After the temperature of the mixture returned to room temperature, it was then placed in an oil bath and continuously refluxed at 85°Cfor overnight, a saturated solution of sodium acetate (150 ml) was then added and stirred for at least 6 hours before extracting with dichloromethane (70 ml each time) for at least 3 times. The organic layers were pooled together and dried with anhydrous MgSO₄. The dried organic layer was filtered, and the solvent was removed by a cyclone condenser. The obtained product was then purified by column chromatography (moving phase: hexane/CH₂Cl₂ = 4/1). An orange solid was obtained. (1.725 g; yield: 78.8%)

¹H NMR (ppm, CDCl₃)□7.21, (dd, 1H), 7.49(d, 1H), 7.82(d, 1H), 7.88(d, 1H), 7.97(d, 1H), 8.15(dd, 1H), 8.17(d, 1H)

### 1.5 The synthesis of 2-cyano-3-(5-(7-thiophen-2-yl)-2,1,3-benzothiadiazole-4-yl)thiophen-2-yl) acrylic acid

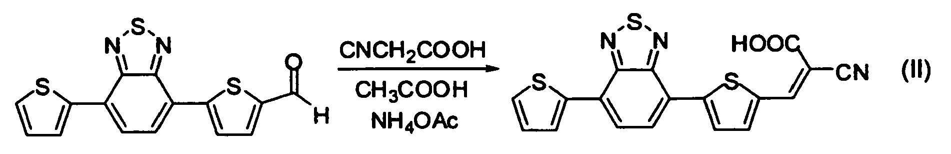

5-7-(thiophen-2-yl)-2,1,3-benzothiadiazole-4-yl)thiophen-2-carbaldehyde example 1.4 (0.9983 g, 3.04 mmole) was placed into a rounded flask, the cyanoacetic acid (0.26 g, 3.06 mmole), ammonium acetate (62 mg, 0.8 mmole) and acetic acid (20 ml) were added. The mixture was relfuxed in an oil bath of about 120°C for at least 5 hours. After the reaction was completed, the oil bath was removed and the solution was allowed to cool down until its temperature had returned to room temperature. The resulted solid was collected by vaccum filtration, and washed several times with deionized water, mthanol, and ester, respectively. The solid was dried in an oven of about 50°C and the dark red color solid was the compound of formula (II). (0.933 g, yield: 77.6%) ¹H NMR (ppm, DMSO-d6)□7.28(dd, 1H), 7.81(d, 1H), 8.08(d, 1H), 8.14(d, 1H), 8.21(d, 1H), 8.26(d, 1H), 8.29(d, 1H), 8.52(.s, 1H) ¹³C NMR (ppm, DMSO-d6)□98.83, 116.45, 123.30, 125.46, 126.95, 127.81, 127.83, 128.19, 128.21, 129.23, 136.68, 138.05, 139.84, 146.41, 147.24, 151.47, 151.52, 163.52

### EXAMPLE 2 FABRICATION AND CHARACTERIZATION OF SOLAR CELL

### 2.1 The Fabrication of Organic Soar Cell A

P3HT and PCBM (12 mg, purchased from Nano-C Inc Southwest Park, Westwood, MA. USA) were dissolved in dichlorobenzene (DCB) (1.0 ml) and the resulted solution was termed "Solution 1".

An indium tin oxide (ITO) conductive glass substrate was pre-cleaned with de-ionized water and suitable solvents including, but not limiting to, methanol and propanol. The substrate was then air-dried and spin-coated with a layer of PEDOT: PSS film on one surface. Placed the substrate in an oven and baked at 140°C for about 10 minutes, then the device was transferred to a sleeve-box in the presence of nitrogen, and further spin-coated with "Solution 1" to form an organic film on the PEDOT:PSS layer. Then, a layer of electrode was deposited on the organic layer formed from "Solution 1" by thermal deposition, and thereby forming an organic solar cell.

Specifically, the electrode layer (Ca/Al) was formed by the steps of: thermal depositing in sequence a thin film of Ca (about 20 nm in thickness) and a thin film of aluminum (about 80 nm in thickness) on the organic layer at a reduced pressure of less than 10⁻⁶ torr; and the device was packaged in the presence of nitrogen. The effective area of the thus fabricated device was about 6 mm².

### 2.2 The Fabrication of Organic Soar Cell B

The solar cell was fabricated in accordance with the steps described in Example 2.1, except the organic layer formed from "Solution 1" was annealed at 160°C for 30 minutes before the electrode layer was formed thereon

### 2.3 The Fabrication of Organic Soar Cell C

The compound of Example 1 (2 mg) was added in "Solution 1", and the mixture was stirred at 40°C for 12 hours to form "Solution 2".

The solar cell was fabricated in accordance with the steps described in Example 2.1, except "Solution 2" was used to form the organic layer.

### 2.4 The Fabrication of Organic Soar Cell D

The solar cell was fabricated in accordance with the steps described in Example 2.3, except the organic layer formed from "Solution 2" was annealed at 160°C for 30 minutes before the electrode layer was formed thereon.

### 2.5 Characterization of the Organic Solar Cells of Examples 2.1 to 2.4

The as-made solar cells of Examples 2.1 to 2.4, that is, solar cells A to D, were fixed onto an I-V curve measuring platen, respectively, and the I-V response of each solar cell was measured under Air Mass (A.M.) 1.5 Global solar conditions by use of an Oriel 500 W light source. Results are provided in Table 1.

| | Voc (V) | Jsc (mA/cm²) | Filled Factor (%) | Photo-Voltaic Converting efficiency (%) | Annealed Temp. (°C) | Annealed Time (min) |
|---|---|---|---|---|---|---|
| Comparison Example* | 0.6V | 3.83 | 30 | 0.82 | | |
| Example 2.1 | 0.64 | 5.06 | 52.6 | 1.70 | - | - |
| Solar Cell A | | | | | | |
| Including an organic layer | | | | | | |
| formed from "Solution 1" | | | | | | |
| Without annealing | | | | | | |
| Example 2.2 | 0.60 | 7.17 | 65.0 | 2.81 | 160 | 30 |
| Solar Cell B | | | | | | |
| Including an organic layer | | | | | | |
| formed from "Solution 1" | | | | | | |
| annealed at 160°C, 30 min | | | | | | |
| Example 2.3 | 0.57 | 7.78 | 56.0 | 2.47 | - | - |
| Solar Cell C | | | | | | |
| Including an organic layer | | | | | | |
| formed from "Solution 2" | | | | | | |
| Without annealing | | | | | | |
| Example 2.4 | 0.63 | 8.72 | 62.3 | 3.42 | 160 | 30 |
| Solar Cell D | | | | | | |
| Including an organic layer | | | | | | |
| formed from "Solution 2" | | | | | | |
| annealed at 160°C, 30 min | | | | | | |

| | | | | | | |
|---|---|---|---|---|---|---|
| * Data in this example was directly taken from Adv. Funct. Mater. (2005), 15: 1617-. | | | | | | |

It is clear from Table 1 that the solar cell formed from the coating solution including the dye-dopant of formula (II) (e.g., the compound of Example 1) possess a higher filled-factor, and thereby a higher photo-voltaic converting efficiency with or without any heat treatment (e.g., being annealed at 160°C for 30 min). This unexpected result was mainly due to the novel dye-dopant of this disclosure being included in the active layer of the solar device, which increased the short current and thereby the photo-voltaic converting efficiency of the device. The photo-voltaic converting efficiency was about 2.47% when the substrate was not subjected to heat treatment, and was about 3.42% when heat treatment was applied. In sum, photo-voltaic converting efficiency increases for about 1.45 folds when heat treatment is applied.

### Industrial Applicability

This disclosure provides a novel dye-dopant for use in an active layer of a solar cell. The novel dye-dopant may enhance the photo-voltaic converting efficiency of the solar device, and may further reduce or eliminate the heat treatment step required for packaging a solar device, particularly a solar device made from a flexible substrate. The photo-voltaic converting efficiency of the solar device is about 2.47% and 3.42%, respectively, with and without the heat-annealing step.

## Claims

1. A dye-dopant having formula (I): 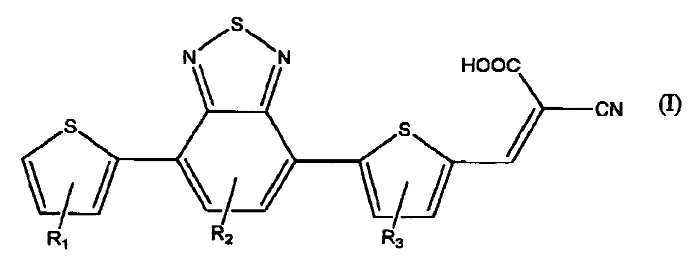 wherein R₁, R₂ and R₃ are independently hydrogen or C₁₋₈alkyl.

2. The dye-dopant of claim 1, wherein R₁, R₂ and R₃ are independently hydrogen.

3. A composition for fabricating an organic solar cell, comprising:
poly-(3-hexylthiophene) (P3HT);
the dye-dopant of claim 1 or 2; and
[6,6]-phenyl-C61-butyric acid methyl ester (PCBM);
wherein the P3HT, the dye dopant of claim 1 and the PCBM exist in the composition in a weight ratio ranges from 3:1:3 to 10:1:10.

4. The composition of claim 3, wherein the weight ratio of P3HT, the dye-dopant of claim 1 and the PCBM in the composition is 7,5:1:7,5.

5. An organic solar cell, comprising a substrate, which comprises in sequence:
a layer of indium tin oxide (ITO) disposed on the substrate;
a layer of PEDOT:PSS disposed on the ITO layer;
an organic layer formed from the composition of claim 3 or 4 on the ITO layer, and
an electrode disposed on the organic layer; wherein the electrode has not been annealed.

6. The solar cell of claim 5, wherein the electrode comprises aluminum.

7. The solar cell of claim 5, wherein the solar cell has a photo-voltaic converting efficiency of about 2,47%.

8. An organic solar cell, comprising a substrate, which comprises in sequence:
a layer of indium tin oxide (ITO) disposed on the substrate;
a layer of PEDOT:PSS disposed on the ITO layer;
an organic layer formed from the composition of claim 3 or 4 on the ITO layer, and
an electrode disposed on the organic layer; wherein the electrode is annealed at a temperature of about 120-180°C for about 10-60 minutes.

9. The solar cell of claim 8, wherein the electrode comprises aluminum.

10. The solar cell of claim 9, wherein the solar cell has a photo-voltaic converting efficiency of about 3,42%.

## Patentansprüche

1. Farbdotierstoff, dessen Formel umfasst: 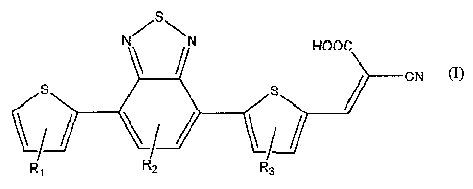 wobei R₁, R₂ und R₃ unabhängig für Wasserstoff oder C₁₋₈ alkyl stehen.

2. Farbdotierstoff nach Anspruch 1, bei welchem R₁, R₂ und R₃ unabhängig für Wasserstoff stehen.

3. Zusammensetzung zur Herstellung einer organischen Solarzelle, die umfasst:
poly-(3-hexylthiophen) (P3HT);
den Farbdotierstoff nach Anspruch 1 oder 2; und
[6,6]-phenyl-C61-Butansäuremethylester (PCBM);
wobei das P3HT, der Farbdotierstoff nach Anspruch 1 und der PCBM in einem Gewichtsverhältnis im Bereich von 3:1:3 bis 10:1:10 vorliegen.

4. Zusammensetzung nach Anspruch 3, bei welcher das Gewichtsverhältnis von P3HT, dem Farbdotierstoff nach Anspruch 1 und dem PCBM in der Zusammensetzung 7,5:1:7,5 ist.

5. Organische Solarzelle, die ein Substrat umfasst, welches in der Reihenfolge umfasst:
eine Schicht Indiumzinnoxid (ITO), die auf dem Substrat angeordnet ist,
eine Schicht PEDOT:PSS, die auf der ITO Schicht angeordnet ist,
eine organische Schicht, die aus der Zusammensetzung nach Anspruch 3 oder 4 auf der ITO Schicht ausgebildet ist und
eine Elektrode, die auf der organischen Schicht angeordnet ist, wobei die Elektrode nicht getempert wurde.

6. Solarzelle nach Anspruch 5, bei welcher die Elektrode Aluminium umfasst.

7. Solarzelle nach Anspruch 5, wobei die Solarzelle eine photovoltaische Umwandlungseffizienz von ungefähr 2,47% aufweist.

8. Organische Solarzelle, die ein Substrat umfasst, welches in der Reihenfolge umfasst:
eine Schicht Indiumzinnoxid (ITO), die auf dem Substrat angeordnet ist,
eine Schicht PEDOT:PSS, die auf der ITO Schicht angeordnet ist,
eine organische Schicht, die aus der Zusammensetzung nach Anspruch 3 oder 4 auf der ITO Schicht ausgebildet ist und
eine Elektrode, die auf der organischen Schicht angeordnet ist, wobei die Elektrode bei einer Temperatur von ungefähr 120 -160 °C für ungefähr 10 - 60 Minuten getempert wurde.

9. Solarzelle nach Anspruch 8, bei welcher die Elektrode Aluminium umfasst.

10. Solarzelle nach Anspruch 9, wobei die Solarzelle eine photovoltaische Umwandlungseffizienz von ungefähr 3,42% aufweist.

## Revendications

1. Dopant colorant ayant la formule (I) : 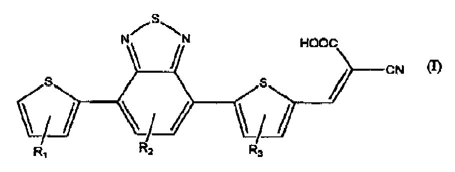 dans lequel R₁, R₂ et R₃ sont indépendamment de l'hydrogène ou un alkyle en C₁₋₈.

2. Dopant colorant selon la revendication 1 dans lequel R₁, R₂ et R₃ sont indépendamment de l'hydrogène.

3. Composition pour fabriquer une cellule solaire organique comprenant :
du poly-(3-hexylthiophène) (P3HT),
le dopant colorant selon la revendication 1 ou 2 et
de l'ester méthylique de l'acide [6,6]-phényl-C61 butyrique (PCBM),
dans laquelle le P3HT, le dopant colorant selon la revendication 1 et le PCBM existent dans la composition dans un rapport de poids de l'ordre de 3:1:3 à 10:1-10.

4. Composition selon la revendication 3 dans laquelle le rapport de poids du P3HT, du dopant colorant selon la revendication 1 et du PCBM dans la composition est 7,5:1:7,5.

5. Cellule solaire organique comprenant un substrat qui comprend dans l'ordre :
une couche d'oxyde d'indium dopé à l'étain (ITO) placée sur le substrat,
une couche de PEDOT:PSS placée sur la couche d'ITO,
une couche organique formée de la composition selon la revendication 3 ou 4 sur la couche d'ITO et
une électrode placée sur la couche organique, l'électrode n'ayant pas été recuite.

6. Cellule solaire selon la revendication 5 dans laquelle l'électrode comprend de l'aluminium.

7. Cellule solaire selon la revendication 5 dans laquelle la cellule solaire a une efficacité de conversion photovoltaïque d'environ 2,47 %.

8. Cellule solaire organique comprenant un substrat qui comprend dans l'ordre :
une couche d'oxyde d'indium dopé à l'étain (ITO) placée sur le substrat,
une couche de PEDOT:PSS placée sur la couche d'ITO,
une couche organique formée de la composition selon la revendication 3 ou 4 sur la couche d'ITO et
une électrode placée sur la couche organique, l'électrode étant recuite à une température d'environ 120-160°C pendant environ 10 à 60 minutes.

9. Cellule solaire selon la revendication 8 dans laquelle l'électrode comprend de l'aluminium.

10. Cellule solaire selon la revendication 9 dans laquelle la cellule solaire a une efficacité de conversion photovoltaïque d'environ 3,42 %.
